# EUROPÄISCHE PATENTSCHRIFT

(11) **EP 2 673 768 B1**
(45) Veröffentlichungstag und Bekanntmachung des Hinweises auf die Patenterteilung: **09.11.2016**
(21) Anmeldenummer: 12706213.1
(22) Anmeldetag: 06.02.2012
(51) Int. Cl.: G10K 11/178, H01L 41/08, H01L 41/047, C03C 17/34

(54) **TRANSPARENTE AKUSTISCH WIRKSAME VORRICHTUNG**
TRANSPARENT ACOUSTICALLY ACTIVE DEVICE
DISPOSITIF ACTIF ACOUSTIQUE TRANSPARENT

(30) Priorität: 07.02.2011 DE 102011000528
(43) Veröffentlichungstag der Anmeldung: 18.12.2013
(73) Patentinhaber: Deutsches Zentrum für Luft- und Raumfahrt e.V., 51147 Köln (DE)
(72) Erfinder: MELCHER, Jörg, 38165 Lehre (Groß Brunsrode) (DE); GÜNSTER, Jens, 38678 Clausthal-Zellerfeld (DE)
(74) Vertreter: REHBERG HÜPPE + PARTNER
(86) Internationale Anmeldenummer: PCT/EP2012/051936
(87) Internationale Veröffentlichungsnummer: WO 2012/107388

(56) Entgegenhaltungen:
- WO-A1-97/16817
- JP-A- 6 335 089
- JP-A- 61 166 300
- JP-A- 2006 286 963
- JP-A- 2008 216 523
- US-A1- 2007 046 642

## Beschreibung

### TECHNISCHES GEBIET DER ERFINDUNG

Die Erfindung bezieht sich auf eine akustisch wirksame Vorrichtung mit den Merkmalen des Oberbegriffs des unabhängigen Patentanspruchs 1.

In einer speziellen Ausführung bezieht sich die vorliegende Erfindung auf die Schallreduktion an Fenstern. Ein ideales Fenster lässt Licht durch, Schall jedoch nicht. Passiver Schallschutz bei Fenstern stößt im Bereich tiefer Frequenzen an Grenzen.

### STAND DER TECHNIK

Neben passiven Schallschutzsystemen sind auch aktive Schallschutzsysteme an Fenstern bekannt. Nach Bauers, R. et al: "Ein Antischallfenster mit Dreifachverglasung", Tagungsband der DAGA 2005 in München, S. 105-106 (2005), werden elektrodynamische Lautsprechersysteme im Bereich des Rahmens eines Fensters zwischen den Glasscheiben angebracht. Der Erfolg wird mit bis zu 15 dB beim Schalldämmmaß benannt. Allerdings resultieren aus diesem bekannten Schallschutzsystem schlechte Wärmedämmwerte, da der Bereich zwischen der mittleren und der inneren Glasscheibe der Dreifachverglasung nicht mehr luftdicht abgeschlossen ist, und Einbrüche im Schalldämmmaß des Fensters im Frequenzbereich oberhalb von 2.500 Hz durch sehr große Abstände der Glasscheiben.

Aus Intelligente Materialien - Neue Fenster gegen Lärm. n-tv, 11.04.2008. Im Internet: <URL: http//www.n-tv.de/wissen/Neue-Fenster-gegen-Laerm-article261268.html> ist ein von Forschern der Technischen Universität Darmstadt und des Fraunhofer-Instituts für Betriebsfestigkeit und Systemzuverlässigkeit (LBF) im Rahmen des EU-Projekts InMar (Intelligent Materials for Active Noise Reduction) entwickeltes "intelligentes" Schallschutzfenster bekannt. Auf der Scheibe klebt ein Beschleunigungssensor, der die Schwingungen misst. Ein ebenfalls auf dem Fenster klebendes Piezoplättchen erzeugt eine Schwingung, die der des Schalls entgegengesetzt ist und diese ausgleicht. Vor der Markteinführung müssten die Piezoplättchen noch unsichtbar gemacht werden.

Zur aktiven Schallreduktion ist auch vorgeschlagen worden, flache Substrate mit sogenannten Piezo-Patches zu versehen und mit Hilfe dieser Piezo-Patches einen mechanisch-elektrischen Schwingkreis aufzubauen, der als Schwingungstilger für die flachen Substrate wirkt, oder die Piezo-Patches aktiv anzusteuern, um die Substrate zu Schwingungen anzuregen. Die Substrate können so als Lautsprechermembran für die Erzeugung von Antischall verwendet werden, oder um die Impedanzeigenschaften des Substrats für hindurch tretenden Schall zu modifizieren.

Die oben erwähnten Piezo-Patches sind beispielsweise in Form des Produkts DuraAct™ der Firma PI Ceramic GmbH, Lederhose, Deutschland (www.piceramic.de) bekannt. In der Produktbeschreibung "DuraAct™ - Piezoelektronische Flächenwandler für Industrie und Forschung" ist unter Anderem eine Anordnung derartiger Piezo-Patches auf einem transparenten Rohr gezeigt, die die Merkmale des Oberbegriffs des unabhängigen Patentanspruchs 1 aufweist. Die bekannten Piezo-Patches sind grundsätzlich nicht transparent.

Unter TCO (Transparent and Conductive Oxide) versteht man im sichtbaren Bereich transparente, aber leitfähige Oxidmaterialien, insbesondere aus dotiertem Zinkoxid (ZnO) oder Zinnoxid (SnO₂). Diese werden umfangreich in der Solarindustrie als transparente, leitfähige Flächenkontakte für Solarzellen auf Halbleiterbasis eingesetzt. Die Dotierungen zur Verbesserung der Leitfähigkeit dieser Oxidmaterialien bestehen in der Regel aus Bor oder Fluor. Schichten aus den Oxidmaterialien werden großtechnisch durch chemische Dampfablagerung (Chemical Vapour Deposition = CVD) oder physikalische Dampfablagerung (Physical Vapour Deposition = PVD) auf den jeweiligen Substraten ausgebildet.

Zur Ausbildung von Filmen auf Substraten werden auch Sputtertechniken eingesetzt. Aus der JP 60 124 111 ist eine Hochfrequenz-Sputtertechnik zur Herstellung einer Zinkoxid-Schicht mit C-Achsen-Orientierung auf einem Siliziumsubstrat bekannt.

Aus Johnson, R. L.: "Characterization of piezoelectric ZnO thin films and the fabrication of piezoelectric micro-cantilevers", Masterarbeit vorgelegt an der lowe State University (2005), ist die Verwendung einer beidseitig mit metallischen Kontakten versehenden ZnO-Schicht als piezoelektrischer Dünnfilm zur Verformung eines Hebelarms, auf dem dieser Schichtaufbau aufgebracht ist, bekannt. Die piezoelektrische Aktivität einer undotierten oder zumindest nicht in einer eine elektrische Leitfähigkeit bereitstellenden Weise dotierten ZnO-Schicht ist von der Texturierung der Schicht abhängig, wobei eine C-Achsen-Orientierung für einen maximalen piezoelektrischen Effekt günstig ist.

Aus der DE 102 96 795 T5 ist ein akustischer Dünnfilmvolumenresonator bekannt, der eine piezoelektrische Schicht zwischen zwei Elektroden aufweist. Als piezoelektrisches Material kommt vorzugsweise Aluminiumnitrid oder Zinkoxid zum Einsatz. Die Elektroden sind vorzugsweise aus Molybdän ausgebildet.

Eine akustisch wirksame Vorrichtung mit den Merkmalen des Oberbegriffs des unabhängigen Patentanspruchs 1 in Form eines Fensters ist aus der WO 97/16817 bekannt. Hier weisen die TCO-Schichten der beiden Elektroden Indiumzinnoxid (Indium Tin Oxide (ITO)) auf.

Aus der US 2007/0046642 A1 ist ein Bildschirm-Tastfeld mit einem Substrat, beispielsweise aus Glas, bekannt, auf dem nacheinander eine erste transparente Elektrode, eine piezoelektrische Schicht und eine zweite transparente Elektrode angeordnet sind. Die transparenten Elektroden umfassen elektrisch leitfähige und optisch transparente Materialien, wie z. B. Indiumzinnoxid (ITO) oder Indiumzinkoxid (IZO). Die piezoelektrische Schicht umfasst ein Polyvinylidenfluorid, ein Poly-a-Methyl-I-Glutamat, ein Polyvinylchlorid oder ein Polytrifluorethylen.

Aus der JP 2008-216523 A ist eine elektrooptische Vorrichtung bekannt, die ein Glassubstrat, eine erste transparente Elektrode, eine piezoelektrische Schicht und eine zweite transparente Elektrode aufweist. Für die piezoelektrische Schicht wird Zinkoxid (ZnO) verwendet. Für die erste transparente Elektrode und die zweite transparente Elektrode wird ITO verwendet. Wenn Staub oder Schmutz an der freien Oberfläche des Substrats anhaftet, wird die piezoelektrische Schicht in Schwingungen versetzt, indem eine Spannung zwischen den transparenten Elektroden angelegt wird, um den Staub oder Schmutz von der Oberfläche abzuschütteln.

Aus der JP 6-335089 A ist ein transparentes piezoelektrisches Element bekannt, das zwischen einer Trägerschicht und einer Schutzschicht transparente Elektrodenschichten aus ITO und dazwischen eine piezoelektrische Schicht aus einem Vinylidenfluorid-Trifluorethylen-Copolymer aufweist.

Aus der JP 61-166300 A ist ein piezoelektrischer Lautsprecher bekannt, der ein transparentes Polykarbonatsubstrat aufweist, auf dem zwischen transparenten Schichten aus 95 % Indiumoxid und 5 % Zinnoxid eine piezoelektrische Schicht aus ZnO angeordnet ist.

### AUFGABE DER ERFINDUNG

Der vorliegenden Erfindung liegt die Aufgabe zugrunde, eine akustisch wirksame Vorrichtung aufzuzeigen, mit der der Schallschutz an Gebäuden ohne Inkaufnahme von Nachteilen grundsätzlich verbessert werden kann.

### LÖSUNG

Die Aufgabe der Erfindung wird durch eine Vorrichtung mit den Merkmalen des unabhängigen Patentanspruchs 1 gelöst. Bevorzugte Ausführungsform der neuen Vorrichtung sind in den Unteransprüchen definiert.

### BESCHREIBUNG DER ERFINDUNG

Bei der erfindungsgemäßen akustisch wirksamen Vorrichtung mit einem Substrat, das zumindest in einem Durchsichtbereich transparent ist, mindestens einer auf dem Substrat angeordneten ersten Elektrode, einer auf der mindestens einen ersten Elektrode angeordneten piezoelektrischen Schicht und mindestens einer auf der piezoelektrischen Schicht angeordneten zweiten Elektrode sind die mindestens eine erste Elektrode und die mindestens eine zweite Elektrode TCO-Schichten, das heißt Schichten aus transparenten und leitfähigen Oxiden, und die piezoelektrische Schicht ist aus einem transparenten piezoelektrischen Material ausgebildet und erstreckt sich vollflächig über den transparenten Durchsichtbereich des Substrats. Der Durchsichtbereich wird bei der erfindungsgemäßen akustisch wirksamen Vorrichtung häufig durch einen Rahmen begrenzt sein, d. h. er macht den gesamten sichtbaren und durchsichtigen Bereich des Substrats innerhalb dieses Rahmens aus.

Der gesamte Schichtaufbau der erfindungsgemäßen akustisch wirksamen Vorrichtung einschließlich des Substrats ist in dem Durchsichtbereich transparent, und der Schichtaufbau auf dem Substrat ist in dem Durchsichtbereich unsichtbar. Transparent bedeutet hier, dass eine Transparenz im Bereich des sichtbaren Lichts gegeben ist. Diese Transparenz lässt aber durchaus einen deutlich gegenüber 1 reduzierten Transmissionsfaktor bei allen, verschieden oder auch nur einzelnen Wellenlängen des sichtbaren Bereichs zu. Auch dann ist der gesamte Schichtaufbau der neuen Vorrichtung noch durchsichtig. Unsichtbar bedeutet hier, dass der Schichtaufbau, der für die Erzeugung von Schall oder Antischall verwendbar ist, als solcher nicht optisch in Erscheinung tritt, sondern allenfalls den optischen Eindruck irgendeiner Beschichtung des Substrats in dem Durchsichtbereich erweckt, wie sie aus irgendeinem optischen Grund vorgesehen sein kann. Die Unsichtbarkeit des Schichtaufbaus beruht nicht zuletzt auf der vollflächigen Überdeckung des Durchsichtbereichs des Substrats mit dem transparenten piezoelektrischen Material. D. h. ein Betrachter sieht nicht durch aneinander angrenzende Bereiche des Substrats hindurch, von denen der eine mit dem piezoelektrischen Material bedeckt ist, der andere jedoch nicht, wodurch ein optischer Kontrast entstehen kann. Dabei schließt eine vollflächige Bedeckung nicht aus, dass eine Unterteilung in einzelne Bereiche vorliegt, soweit diese mit dem bloßen menschlichen Auge nicht aufgelöst wird. Dies ist dann von besonderer Bedeutung, wenn - was aus dem Aspekt der Unsichtbarkeit des Schichtaufbaus bevorzugt ist - auch die mindestens eine erste Elektrode und die mindestens eine zweite Elektrode den Durchsichtbereich oder gar das ganze Substrat vollflächig bedecken. So können zum Beispiel mehrere erste Elektroden so dicht nebeneinander auf dem Substrat angeordnet sein, dass für einen Betrachter kein Übergang zu erkennen ist.

Grundsätzlich kann das gesamte Substrat der erfindungsgemäßen akustisch wirksamen Vorrichtung transparent sein. Ebenso kann das piezoelektrische Material das gesamte Substrat vollflächig bedecken.

Um die akustische Wirksamkeit der erfindungsgemäßen Vorrichtung mit kleinen elektrischen Energien bei der Ansteuerung ihrer Elektroden hervorrufen zu können, ist es bevorzugt, wenn das Substrat mit den darauf angeordneten Schichten eine Resonanzfrequenz im akustischen Bereich aufweist. Besonders bevorzugt ist es, wenn die zugehörige Eigenform des Substrats ein Schwingungsbauch im Bereich einer der ersten und/oder zweiten Elektroden aufweist, so dass sie mit diesen Elektroden gezielt angesteuert werden kann.

Das Substrat besteht vorzugsweise wegen seiner Beschichtungseigenschaften und seiner mechanischen Eigenschaften aus Glas.

Die erfindungsgemäße akustisch wirksame Vorrichtung kann an einer Fensterscheibe verwirklicht sein, um die Fläche der Fensterscheibe zur Schalldämpfung zu nutzen, entweder unter Integration des durch den Schichtaufbau realisierten mechanisch-elektrischen Wandlers in einen mechanisch-elektrischen Schwingkreis, der als Schwingungstilger wirkt, oder durch Ansteuerung des mechanisch-elektrischen Wandlers zur Erzeugung von Antischall, das heißt von Schallwellen, die auftretenden Lärm durch destruktive Überlagerung auslöschen. Der Durchsichtbereich des Substrats ist dann der von dem Fensterrahmen begrenzte Bereich der Fensterscheibe.

Der Schichtaufbau der erfindungsgemäßen Vorrichtung ist insbesondere dann optisch unauffällig, wenn die jeweilige Fensterscheibe sowieso mit ihre Transparenz gezielt einstellenden Beschichtungen versehen ist. Diese Beschichtungen können durch den Schichtaufbau der erfindungsgemäßen Vorrichtung auch ganz oder zumindest teilweise ersetzt werden.

Das Substrat der erfindungsgemäßen akustisch wirksamen Vorrichtung kann auch eine Abdeckscheibe eines Displays sein, um im Idealfall eine Lautsprecher für eine akustische Ausgabe zusätzlich zu der optischen des Displays auszubilden. In diesem Fall kann die mindestens eine zweite Elektrode eine Gegenelektrode einer Anzeigeeinrichtung, wie bspw. einer Leucht- oder Flüssigkristallanzeige des Displays sein.

Die erste Elektrode der erfindungsgemäßen Vorrichtung kann auf das Substrat zum Beispiel aufgedampft oder aufgesputtert sein, wobei alle im Stand der Technik bekannten Aufdampf- und Sputterverfahren zur Anwendung kommen können.

Vorzugsweise ist der aus dem Schichtaufbau der erfindungsgemäßen Vorrichtung resultierende mechanisch-elektrische Wandler in Teilwandler unterteilt, die sich jeweils nur über eine Teilfläche des Substrats erstrecken. Bei einem aktiv angesteuerten mechanisch-elektrischen Wandler kann die Ansteuerung so beispielsweise auf die einzelnen Bereiche des Substrats optimal angepasst werden.

Die Unterteilung des mechanisch-elektrischen Wandlers in Teilwandler erfolgt vorzugsweise dadurch, dass eine Mehrzahl von einzeln ansteuerbaren ersten Elektroden nebeneinander auf dem Substrat angeordnet ist. Dies wiederum kann konkret dadurch realisiert werden, dass eine zunächst durchgängig auf das Substrat aufgebrachte erste Elektrodenschicht vor dem Aufbringen der piezoelektrischen Schicht unterteilt wird. Dieses Unterteilen kann zum Beispiel durch lokales Verdampfen der ersten Elektrodenschicht mit einem von dieser ersten Elektrodenschicht selektiv absorbierten Laserstrahl erfolgen. Dabei reichen zur Unterteilung der durchgängigen ersten Elektrodenschicht in einzeln ansteuerbare erste Elektroden relativ schmale freie Bereiche von typischerweise 10 bis 100 µm Breite.

Die piezoelektrische Schicht wird vorzugsweise auf die mindestens eine oder die Mehrzahl der ersten Elektroden aufgedampft oder aufgesputtert, wobei hier wiederum alle aus dem Stand der Technik bekannten Aufdampf- und Sputterverfahren zur Anwendung kommen können, insbesondere aber solche, die sich auf die Größe des gewünschten piezoelektrischen Effekts der piezoelektrischen Schicht günstig auswirken. Dies bedeutet vor allem, dass eine für den gewünschten piezoelektrischen Effekt günstige Textur eingestellt wir.

Auf die piezoelektrische Schicht wird dann die mindestens eine zweite Elektrode aufgebracht, vorzugsweise wiederum aufgedampft oder aufgesputtert, wobei auch hier alle aus dem Stand der Technik bekannten Aufdampf- und Sputterverfahren zur Anwendung kommen können.

Eine Unterteilung des durch den Schichtaufbau der neuen Vorrichtung realisierten mechanisch-elektrischen Wandlers in Teilwandler kann grundsätzlich auch im Bereich der zweiten Elektrode realisiert sein, in dem eine Mehrzahl von einzeln ansteuerbaren zweiten Elektroden auf dem Substrat ausgebildet wird. Dies kann ebenfalls dadurch geschehen, dass eine zunächst auf die piezoelektrische Schicht aufgebrachte durchgängige zweite Elektrodenschicht in die Mehrzahl von einzeln ansteuerbaren zweiten Elektroden unterteilt wird. Auch hierfür ist hochenergetische Licht, insbesondere ein Laserstrahl einsetzbar, der vorzugsweise selektiv von dem Material der zweiten Elektrode absorbiert wird.

Bei der erfindungsgemäßen Vorrichtung kann der Schichtaufbau auf dem Substrat vollflächig über allen zweiten Elektroden mit einer durchgängigen transparenten Abdeckschicht abgedeckt sein. Diese Abdeckschicht schützt den Aufbau des mechanisch-elektrischen Wandlers, beispielsweise beim Reinigen einer auf Basis der vorliegenden Erfindung ausgebildeten aktiven Fensterscheibe. Allerdings zählen die für die mindestens eine zweite Elektrode zu verwendenden transparenten und leitfähigen Oxide bereits zu den harten Beschichtungen. Die Abdeckschicht kann darüber hinaus vorgesehen sein, die piezoelektrische Schicht der erfindungsgemäßen Vorrichtung gezielt unter eine mechanische Vorspannung zu setzen, die für den Betrieb des mechanisch-elektrischen Wandlers und insbesondere eine zerstörungsfreie Verwendung der piezoelektrischen Schicht von Vorteil ist. Darüber hinaus kann die Abdeckschicht auch eine optische Anpassschicht sein, mit der die Gesamttransparenz des erfindungsgemäßen Schichtaufbaus nach Wunsch eingestellt wird.

Konkret sind die TCO-Schichten aus dotiertem Zinnoxid oder Zinkoxid ausgebildet. Als transparentes piezoelektrisches Material für die piezoelektrische Schicht wird undotiertes oder jedenfalls mit keiner seine elektrische Leitfähigkeit erhöhenden Dotierung versehenes Zinkoxid verwendet.

Alle Elektroden der neuen Vorrichtung sind vorzugsweise in einem von einem Rahmen abgedeckten Randbereich des Substrats und damit unsichtbar elektrisch kontaktiert.

Für die dauerhafte Funktion der neuen Vorrichtung kann es von Vorteil sein, wenn zwischen der mindestens einen ersten Elektrode und der piezoelektrischen Schicht und/oder der mindestens einen zweiten Elektrode und der piezoelektrischen Schicht jeweils eine transparente Zwischenschicht als Diffusionsbarriere angeordnet ist. So wird verhindert, dass das transparente piezoelektrische Material der piezoelektrischen Schicht durch Diffusion in einer Weise so verunreinigt wird, dass seine piezoelektrische Funktion in Frage steht.

Vorteilhafte Weiterbildungen der Erfindung ergeben sich aus den Patentansprüchen, der Beschreibung und den Zeichnungen. Die in der Beschreibungseinleitung genannten Vorteile von Merkmalen und von Kombinationen mehrerer Merkmale sind lediglich beispielhaft und können alternativ oder kumulativ zur Wirkung kommen, ohne dass die Vorteile zwingend von allen erfindungsgemäßen Ausführungsformen erzielt werden müssen. Weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche ist auch abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher

Patentansprüche kombiniert werden. Ebenso können in den Patentansprüchen aufgeführte Merkmale für weitere Ausführungsformen der Erfindung entfallen.

### KURZBESCHREIBUNG DER FIGUREN

Die Erfindung wird Im Folgenden anhand von bevorzugten Ausführungsbeispielen unter Bezugnahme auf die beigefügten Zeichnungen näher erläutert und beschrieben.
- **Fig. 1**: zeigt einen Schnitt durch die neue Vorrichtung zur Schalldämpfung in einer ersten Ausführungsform.
- **Fig. 2**: zeigt einen Schnitt durch die neue Vorrichtung in einer zweiten Ausführungsform; und
- **Fig. 3**: zeigt einen Schnitt durch die neue Vorrichtung zur Schalldämpfung in einer dritten Ausführungsform.

### FIGURENBESCHREIBUNG

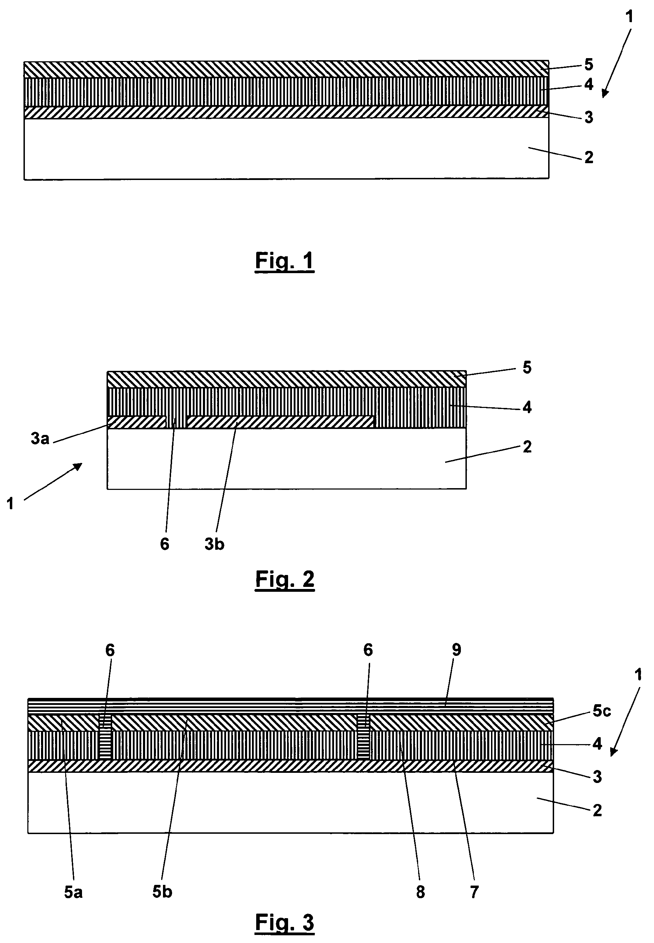

Der in **Fig. 1** gezeigte Schichtaufbau einer Vorrichtung 1 zur Schalldämpfung umfasst ein transparentes Substrat 2, eine auf dem Substrat 2 angeordnete erste Elektrode 3, eine auf der ersten Elektrode 3 angeordnete piezoelektrische Schicht 4 und eine auf der piezoelektrischen Schicht 4 angeordnete zweite Elektrode 5. Dabei sind auch die Elektroden 3 und 5 und die piezoelektrische Schicht 4 transparent. Dazu sind die Elektroden 3 und 5 aus mit Bor oder Fluor dotiertem TCO, beispielsweise leitfähig dotiertem Zinnoxid beziehungsweise Zinkoxid für mindestens die zweite Elektrode 5 ausgebildet, während die piezoelektrische Schicht 4 aus einer elektrisch nicht leitfähigen ZnO-Schicht mit C-Achsen-Orientierung besteht. Die Dicke des Substrats 2 liegt hier beispielsweise bei 4 mm. Die Dicke der ersten Elektrode 3 und der zweiten Elektrode 5 liegt jeweils bei beispielsweise 1 µm, und die Dicke der piezoelektrischen Schicht 4 beispielsweise in einem Bereich von 0,5 bis 100 µm. Dementsprechend ist die Wiedergabe des Schichtaufbaus in Fig. 1 nicht maßstabsgetreu. Das transparente Substrat 2 ist insbesondere eine Fensterscheibe aus Glas, auf die die weiteren Schichten 3 bis 5 durch ein PVD- oder CVD- oder ein Sputterverfahren aufgebracht sind. Eine Kontaktierung der Elektroden 3 und 5 erfolgt in einem hier nicht dargestellten Randbereich des Substrats 2, der im Falle einer Fensterscheibe vorzugsweise von einem Rahmen des jeweiligen Fensters abgedeckt ist, sodass die Kontaktierung der Elektroden 3 und 5 für den Betrachter des vollständigen Fensters unsichtbar ist.

Der in **Fig. 2** dargestellte Schichtaufbau der Vorrichtung 1 unterscheidet sich von demjenigen in Fig. 1 dadurch, dass statt nur einer ersten Elektrode 3 in Form einer durchgängigen Elektrodenschicht auf dem Substrat 2 mehrere erste Elektroden 3a und 3b unter der piezoelektrischen Schicht 4 vorgesehen sind. Getrennt sind die einzelnen ersten Elektroden 3a und 3b durch Freiräume 6 mit einer Breite von typischerweise 10 µm. So können die einzelnen ersten Elektroden 3a und 3b getrennt voneinander angesteuert werden, um einzelne Bereiche des Substrats 2 durch den piezoelektrischen Effekt der piezoelektrischen Schicht 4 unterschiedlich mechanisch zu beaufschlagen beziehungsweise unterschiedlich zu deformieren. Dass die piezoelektrische Schicht 4 in die Freiräume 6 vorsteht, ist dabei unkritisch ebenso wie, dass nur eine einzige zweite Elektrode 5 vorhanden ist. Vielmehr ist es günstig, dass diese eine durchgängige Abschlussschicht des Schichtaufbaus gemäß Fig. 2 ausbildet. Das Ausbilden der Freiräume 6 kann zum Beispiel dadurch erfolgen, dass eine zunächst auf das Substrat 2 aufgebrachte durchgängige erste Elektrodenschicht mit Hilfe von Laserlicht, das mit seiner Wellenlänge auf ein Absorptionsband des Materials der ersten Elektrodenschicht abgestimmt ist, lokal verdampft wird.

**Fig. 3** zeigt einen Schichtaufbau der Vorrichtung 1, bei dem mehrere zweite Elektroden 5a, 5b und 5c vorgesehen sind, während die erste Elektrode 3 eine durchgängige erste Elektrodenschicht ist. Zusätzlich ist hier auch die piezoelektrische Schicht 4 unterteilt, was aber auch hier nicht zwingend ist. Die Freiräume 6, die hier seitlich zwischen den zweiten Elektroden 5a, 5b und 5c vorgesehen sind, sind durch partielles Verdampfen des Materials der zweiten Elektroden 5 und der piezoelektrischen Schicht 4 bei einem zunächst durchgängigen Schichtaufbau entsprechend Fig. 1 ausgebildet worden. Zusätzlich sind in Fig. 3 Zwischenschichten 7 und 8 zwischen der ersten Elektrode 3 und der piezoelektrischen Schicht 4 beziehungsweise der piezoelektrischen Schicht 4 und den zweiten Elektroden 5 wiedergegeben, die als Diffusionsbarrieren zwischen den angrenzenden Schichten wirken. Es versteht sich, dass auch diese Zwischenschichten 7 und 8 bei der Vorrichtung 1 transparent sind. Transparent ist auch eine Abdeckschicht 9, die über den zweiten Elektroden 5 das Substrat 2 vollflächig abdeckt und hierbei auch die Freiräume 6 ausfüllt. Die Abdeckschicht 9 kann die Funktion einer optischen Anpassschicht zur Einstellung gewünschter Transmissionseigenschaften des gesamten Schichtaufbaus 1 und/oder die Funktion haben, die piezoelektrische Schicht 4 gezielt unter eine mechanische Vorspannung zu setzen.

### BEZUGSZEICHENLISTE

- 1: Vorrichtung
- 2: Substrat
- 3: Erste Elektrode
- 4: Piezoelektrische Schicht
- 5: Zweite Elektrode
- 6: Freiraum
- 7: Zwischenschicht
- 8: Zwischenschicht
- 9: Abdeckschicht

## Patentansprüche

1. Akustisch wirksame Vorrichtung (1):
- mit einem Substrat (2), das zumindest in einem Durchsichtbereich transparent ist,
- mit mindestens einer auf dem Substrat (2) angeordneten ersten Elektrode (3),
- mit einer auf der mindestens einen ersten Elektrode (3) angeordneten piezoelektrischen Schicht (4) und
- mit mindestens einer auf der piezoelektrischen Schicht (4) angeordneten zweiten Elektrode (5),
- wobei die mindestens eine erste Elektrode (3) und die mindestens eine zweite Elektrode (5) Schichten aus transparenten leitfähigen Oxidmaterialen sind,
- wobei die piezoelektrische Schicht (4) aus einem transparenten piezoelektrischen Material ausgebildet ist, das sich vollflächig über den Durchsichtbereich erstreckt und
- wobei das piezoelektrische Material Zinkoxid ist,
**dadurch gekennzeichnet,**
- **dass** die transparenten leitfähigen Oxidmaterialien zur Verbesserung der Leitfähigkeit eine Dotierung aus Bor oder Fluor aufweisen und
- **dass** das transparente leitfähige Oxidmaterial der zweiten Elektrode (5) leitfähig dotiertes Zinkoxid ist.

2. Vorrichtung (1) nach Anspruch 1, **dadurch gekennzeichnet, dass** das piezoelektrische Material undotiertes Zinkoxid ist.

3. Vorrichtung (1) nach Anspruch 1 oder 2, **dadurch gekennzeichnet, dass** das transparente leitfähige Oxidmaterial der ersten Elektrode (3) leitfähig dotiertes Zinnoxid oder Zinkoxid ist.

4. Vorrichtung (1) nach einem der Ansprüche 1 bis 3, **dadurch gekennzeichnet, dass** der Durchsichtbereich durch einen Rahmen begrenzt ist.

5. Vorrichtung (1) nach einem der Ansprüche 1 bis 4, **dadurch gekennzeichnet, dass** sich auch die mindestens eine erste Elektrode (3) und/oder die mindestens eine zweite Elektrode (5) vollflächig über den Durchsichtbereich erstreckt.

6. Vorrichtung (1) nach einem der Ansprüche 1 bis 5, **dadurch gekennzeichnet, dass** das Substrat mit den darauf angeordneten Schichten eine Resonanzfrequenz im akustischen Bereich aufweist.

7. Vorrichtung (1) nach einem der Ansprüche 1 bis 6, **dadurch gekennzeichnet, dass** das Substrat aus Glas besteht.

8. Vorrichtung (1) nach einem der Ansprüche 1 bis 7, **dadurch gekennzeichnet, dass** das Substrat (2) eine Fensterscheibe ist.

9. Vorrichtung (1) nach einem der Ansprüche 1 bis 7, **dadurch gekennzeichnet, dass** das Substrat (2) eine Abdeckscheibe eines Displays ist, wobei die mindestens eine zweite Elektrode (5) optional Gegenelektrode einer unter der Abdeckscheibe liegenden Anzeigeeinrichtung ist.

10. Vorrichtung (1) nach einem der Ansprüche 1 bis 9, **dadurch gekennzeichnet, dass** eine Mehrzahl von einzeln ansteuerbaren ersten Elektroden (3a, 3b) auf dem Substrat (2) angeordnet ist, wobei die Mehrzahl von einzeln ansteuerbaren ersten Elektroden (3a, 3b) optional durch Unterteilen einer durchgängigen ersten Elektrodenschicht ausgebildet ist.

11. Vorrichtung (1) nach einem der Ansprüche 1 bis 10, **dadurch gekennzeichnet, dass** die mindestens eine erste Elektrode (3) auf das Substrat (2) aufgedampft oder aufgesputtert ist und/oder dass die piezoelektrische Schicht (4) auf die mindestens eine erste Elektrode (3) aufgedampft oder aufgesputtert ist und/oder dass die mindestens eine zweite Elektrode (5) auf die piezoelektrische Schicht (4) aufgedampft oder aufgesputtert ist.

12. Vorrichtung (1) nach einem der Ansprüche 1 bis 11, **dadurch gekennzeichnet, dass** das Substrat (2) über der mindestens einen zweiten Elektroden (5) in dem Durchsichtbereich vollflächig mit einer transparenten Abdeckschicht (9) abgedeckt ist, wobei die Abdeckschicht (9) die piezoelektrische Schicht (4) optional unter eine mechanische Vorspannung setzt.

13. Vorrichtung (1) nach Anspruch 12, **dadurch gekennzeichnet, dass** die Abdeckschicht (9) eine optische Anpassschicht ist.

14. Vorrichtung (1) nach einem der Ansprüche 1 bis 13, **dadurch gekennzeichnet, dass** alle Elektroden (3, 5) in einem von einem Rahmen abgedeckten Randbereich des Substrats (2) mit Anschlussleitungen elektrisch kontaktiert sind.

15. Vorrichtung (1) nach einem der Ansprüche 1 bis 14, **dadurch gekennzeichnet, dass** zwischen der mindestens einen ersten Elektrode (3) und der piezoelektrischen Schicht (4) sowie zwischen der mindestens einen zweiten Elektrode (5) und der piezoelektrischen Schicht (4) transparente Zwischenschichten (7, 8) als Diffusionsbarrieren angeordnet sind.

## Claims

1. Acoustically active device (1):
- comprising a substrate (2) which is transparent at least in a viewing area,
- comprising at least one first electrode (3) arranged on the substrate (2),
- comprising a piezoelectric layer (4) arranged on the at least one first electrode (3), and
- comprising at least one second electrode (5) arranged on the piezoelectric layer (4),
- wherein the at least one first electrode (3) and the at least one second electrode (5) are layers of transparent conductive oxide materials,
- wherein the piezoelectric layer (4) is made of a transparent piezoelectric material which completely covers the viewing area, and
- wherein the piezoelectric material is zinc oxide,
**characterised in**
- **that** the transparent conductive oxide materials are doped with boron or fluorine for increasing their conductivity and
- **that** the transparent conductive oxide material of the second electrode (5) is conductively doped zinc oxide.

2. Device (1) of claim 1, **characterised in that** the piezoelectric material is undoped zinc oxide.

3. Device (1) of claim 1 or 2, **characterised in that** the transparent conductive oxide material of the first electrode (3) is conductively doped tin oxide or zinc oxide.

4. Device (1) of any of the claims 1 to 3, **characterised in that** the viewing area is delimited by a frame.

5. Device (1) of any of the claims 1 to **4, characterised in that** the at least one first electrode (3) and/or the at least one second electrode (5) also completely cover(s) the viewing area.

6. Device (1) of any of the claims 1 to 5, **characterised in that** the substrate together with the layers arranged thereon has a resonance frequency in the acoustic range.

7. Device (1) of any of the claims 1 to 6, **characterised in that** the substrate is made of glass.

8. Device (1) of any of the claims 1 to 7, **characterised in that** the substrate (2) is a window pane.

9. Device (1) of any of the claims 1 to 7, **characterised in that** the substrate (2) is a clear view screen of a display, wherein, optionally, the at least one second electrode (5) is a counter electrode of a display device located behind the clear view screen.

10. Device (1) of any of the claims 1 to 9, **characterised in that** a plurality of individually controllable first electrodes (3a, 3b) are arranged on the substrate (2), wherein, optionally, the plurality of individually controllable first electrodes (3a, 3b) are made by subdividing a continuous first electrode layer.

11. Device (1) of any of the claims 1 to 10, **characterised in that** the at least one first electrode (3) is vapour- or sputter-deposited on the substrate (2) and/or that the piezoelectric layer (4) is vapour- or sputter-deposited on the at least one first electrode (3) and/or that the at least one second electrode (5) is vapour- or sputter-deposited on the piezoelectric layer (4).

12. Device (1) of any of the claims 1 to 11, **characterised in that** the substrate (2), above the at least one second electrode (5), is completely covered by a transparent cover layer (9) in the viewing area, wherein, optionally, the cover layer (9) applies a mechanical prestress to the piezoelectric layer (4).

13. Device (1) of claim 12, **characterised in that** the cover layer (9) is an optical adaptor layer.

14. Device (1) of any of the claims 1 to 13, **characterised in that** all electrodes (3, 5) are electrically connected to connection lines in a border area of the substrate (2), which is covered by a frame.

15. Device (1) of any of the claims 1 to 14, **characterised in that** transparent intermediate layers (7, 8) are arranged as diffusion barriers between the at least one first electrode (3) and the piezoelectric layer (4), and between the at least one second electrode (5) and the piezoelectric layer (4).

## Revendications

1. Dispositif actif acoustique (1):
- avec un substrat (2) qui est transparent au moins dans une zone transparente,
- avec au moins une première électrode (3) disposée sur le substrat (2),
- avec une couche piézoélectrique (4) disposée sur la première électrode (3) au moins au nombre de un,
- avec au moins une deuxième électrode (5) disposée sur la couche piézoélectrique (4),
- la première électrode (3) au moins au nombre de un et la deuxième électrode (5) au moins au nombre de un étant des couches en matériaux d'oxyde conducteurs transparents,
- la couche piézoélectrique (4) étant constituée d'un matériau piézoélectrique transparent qui s'étend sur toute sa surface au-dessus de la zone transparente, et
- le matériau piézoélectrique étant de l'oxyde de zinc,
**caractérisé en ce que**
- les matériaux d'oxyde conducteurs transparents présentent un dopage par du bore ou du fluor pour l'amélioration de la conductivité, et
- le matériau d'oxyde conducteur transparent de la deuxième électrode (5) est de l'oxyde de zinc dopé pour la conduction.

2. Dispositif (1) selon la revendication 1, **caractérisé en ce que** le matériau piézoélectrique est de l'oxyde de zinc non dopé.

3. Dispositif (1) selon la revendication 1 ou 2, **caractérisé en ce que** le matériau d'oxyde conducteur transparent de la première électrode (3) est de l'oxyde d'étain ou de l'oxyde de zinc dopé pour la conduction.

4. Dispositif (1) selon l'une des revendications 1 à 3, **caractérisé en ce que** la zone transparente est limitée par un cadre.

5. Dispositif (1) selon l'une des revendications 1 à 4, **caractérisé en ce que** la première électrode (3) au moins au nombre de un et/ou la deuxième électrode (5) au moins au nombre de un s'étend également sur la toute sa surface au-dessus de la zone transparente.

6. Dispositif (1) selon l'une des revendications 1 à 5, **caractérisé en ce que** le substrat avec les couches disposées au-dessus présente une fréquence de résonance dans la zone acoustique.

7. Dispositif (1) selon l'une des revendications 1 à 6, **caractérisé en ce que** le substrat se compose de verre.

8. Dispositif (1) selon l'une des revendications 1 à 7, **caractérisé en ce que** le substrat (2) est une vitre de fenêtre.

9. Dispositif (1) selon l'une des revendications 1 à 7, **caractérisé en ce que** le substrat (2) est une vitre de couverture d'un afficheur, la deuxième électrode (5) au moins au nombre de un étant en option une contre-électrode d'un dispositif d'affichage situé sous la vitre de couverture.

10. Dispositif (1) selon l'une des revendications 1 à 9, **caractérisé en ce qu'**une pluralité de premières électrodes (3a, 3b) pouvant être commandées individuellement est disposée sur le substrat (2), la pluralité de premières électrodes (3a, 3b) pouvant être commandées individuellement étant en option constituée par la subdivision d'une première couche d'électrodes continue.

11. Dispositif (1) selon l'une des revendications 1 à 10, **caractérisé en ce que** la première électrode (3) au moins au nombre de un est déposée sur le substrat (2) par dépôt en phase vapeur ou pulvérisation et/ou **en ce que** la couche piézoélectrique (4) est déposée en phase vapeur ou pulvérisée sur la première électrode (3) au moins au nombre de un et/ou **en ce que** la deuxième électrode (5) au moins au nombre de un est déposée en phase vapeur ou pulvérisée sur la couche piézoélectrique (4).

12. Dispositif (1) selon l'une des revendications 1 à 11, **caractérisé en ce que,** au-dessus de la deuxième électrode (5) au moins au nombre de un, le substrat (2) est recouvert sur toute sa surface dans la zone transparente par une couche de couverture (9) transparente, la couche de couverture (9) soumettant en option la couche piézoélectrique (4) à une précontrainte mécanique.

13. Dispositif (1) selon la revendication 12, **caractérisé en ce que** la couche de couverture (9) est une couche d'adaptation optique.

14. Dispositif (1) selon l'une des revendications 1 à 13, **caractérisé en ce que** toutes les électrodes (3, 5) sont mises en contact électrique avec des lignes de connexion dans une zone de bord du substrat (2) recouverte par un cadre.

15. Dispositif (1) selon l'une des revendications 1 à 14, **caractérisé en ce que** des couches intermédiaires (7, 8) transparentes sont disposées en tant que barrières de diffusion entre la première électrode (3) au moins au nombre de un et la couche piézoélectrique (4) ainsi qu'entre la deuxième électrode (5) au moins au nombre de un et la couche piézoélectrique (4).
